# EUROPEAN PATENT APPLICATION

(11) **EP 4 848 964 A1**
(43) Date of publication of application: **02.12.2026**
(21) Application number: 25179554.8
(22) Date of filing: 28.05.2025
(51) Int. Cl.: H10N 60/01, H10N 60/12

(54) **AN IMPROVED JOSEPHSON JUNCTION DEVICE AND METHOD OF PRODUCING THE DEVICE**

(71) Applicant: IMEC VZW, 3001 Leuven (BE)
(72) Inventor: Huet, Benjamin, 1030 Schaarbeek (BE); Perez Lozano, Daniel, 1030 Schaarbeek (BE); Pokhrel, Ankit, 3000 Leuven (BE)
(74) Representative: Patent Department IMEC

(57) **Abstract**

A Josephson junction stack is produced including a first superconducting electrode layer (3), a barrier layer (4',5) directly on the first superconducting electrode layer and a second superconducting electrode layer (6) directly on the barrier layer. The second superconducting electrode layer (6) is formed of a superconducting nitride material, and the barrier layer comprises a stack of an semiconductor material layer (4') and directly on said semiconductor material layer: a passivation layer (5) configured to prevent the semiconductor material from interacting with the N of the superconducting nitride material of the second superconducting electrode layer. The Josephson junction device is produced by patterning the stack.

## Description

### Field of the Invention

The present disclosure is generally related to a Josephson junction device applicable in a superconducting digital logic circuit or qubit controlling unit.

### State of the art.

Superconducting digital logic (SDL) is one of the main technologies of interest for overcoming inherent limitations in terms of energy efficiency of CMOS based integrated circuits. An SDL circuit comprises superconducting wires and Josephson junctions. Josephson junctions are known in various forms, but in SDL circuits, the most common implementation takes the form of a dielectric material sandwiched between two superconducting electrodes. In an SDL circuit, the Josephson junction enables changing the magnetic flux in a superconducting loop by an integer number of a single magnetic flux quantum (SFQ).

The material of choice for the electrodes of Josephson junctions applied in SDL circuits has most often been niobium, with Al₂O₃ or amorphous silicon (hereafter abbreviated as α-Si) as the barrier layer. A Nb/α-Si/Nb stack is however not compatible with standard CMOS process steps which require temperatures higher than 150°C-200°C, such as many steps required in back end of line processing, because the Nb intermixes with silicon above this temperature, thereby reducing the thickness of the barrier. This makes it difficult also to scale down Josephson junctions of this type to the small dimensions required for high density SDL circuits.

### Summary of the invention

The present disclosure is related to a Josephson junction stack and a device obtainable from said stack and a method for producing said stack and said device in accordance with the appended claims. A Josephson junction stack according to the present disclosure comprises a first superconducting electrode layer, a barrier layer on the first superconducting electrode layer and a second superconducting electrode layer directly on the barrier layer. The second superconducting electrode layer is formed of a superconducting nitride material, and the barrier layer comprises a stack of a semiconductor material layer and directly on said semiconductor material layer: a passivation layer configured to prevent the semiconductor material from interacting with the N of the superconducting nitride material of the second superconducting electrode layer.

In case there is no mixture, for example when depositing TiSix directly,he deposited passivation layer is a passivation layer in the sense that it prevents the formation of silicon nitride during or after the formation of the second electrode layer, i.e. it prevents N from the second electrode layer material from reacting with the semiconductor material from the semiconductor material layer. The deposited passivation layer can thus be said to passivate the semiconductor material layer.

In case there is formation of a mixture of the semiconductor material with a second element, the mixed layer is a passivation layer in the sense that it prevents the formation of silicon nitride during or after the formation of the second electrode layer, i.e. it prevents N from the second electrode layer material from reacting with the semiconductor material from the semiconductor material layer. The mixed layer can thus be said to passivate the semiconductor material layer.

The passivation layer may help in several ways:
1) Passivate the semiconductor material layer (e.g. Si or Ge) from interaction (i.e. reaction, in particular examples nitridation) with nitrogen during deposition of the second superconducting electrode layer.
2) Prevent interdiffusion between the semiconductor material layer (e.g. Si or Ge) and the second superconducting electrode layer (e.g. NbN, NbTiN, TaN, TiN,..) during any optional extra processing steps afterwards, or in certain operating conditions (for example when using a higher thermal budget, or electro migration). This leads to a more stable interface.
3) Better control of the semiconductor thickness through controlled interdiffusion between the semiconductor and the transition metal/silicides. The intentional mixing is not mandatory, it will happen for sure for Si/Ti but will not happen for Si/TiSix.

In other words, an effect of the passivation layer is (1) protecting the semiconductor material layer from interdiffusing with the superconducting electrodes, and (2) interdiffusing with the semiconductor material layer to achieve finer control of its resistance and protecting the semiconductor material layer from degradation upon deposition of any materials on top.

The present disclosure is in particular related to a Josephson junction stack comprising a first superconducting electrode layer, a barrier layer on the first superconducting electrode layer and a second superconducting electrode layer on the barrier layer, characterized in that:
- the second superconducting electrode layer is formed of a superconducting nitride material,
- the barrier layer comprises a stack of a semiconductor material layer on the first superconducting electrode layer and directly on said semiconductor material layer: a passivation layer configured to prevent the semiconductor material from interacting with the N of the superconducting nitride material of the second superconducting electrode layer.

Optionally, the first superconducting electrode layer may be formed of a superconducting nitride material as well.

According to an embodiment, the Josephson junction stack comprises a buffer layer, between the semiconductor material layer and the first superconducting electrode layer, configured to prevent an interdiffusion of the semiconductor material into the first superconducting electrode layer.

The buffer layer may help in several ways:
i) In the case the first superconducting electrode layer and the semiconductor material layer have a high affinity (which is the case for Nb/Si..., and maybe for NbN/Si as well), it can help to prevent any interdiffusion, thus maintaining the proper superconducting properties of the electrode and the barrier effect of the semiconductor.
ii) It affords a better control of the semiconductor material layer thickness through a controlled interdiffusion between the semiconductor material and the transition metal / silicides. Intentional mixing is not mandatory; for example, it will occur for Ti/Si/Ti but not for TiSix/Si/TiSix.

According to an embodiment, a thickness of the semiconductor material layer, after allowing sufficient time for intermixing with any adjacent layers, is thinner than the thickness of the combination of the passivation layer and, if present, the buffer layer, including any intermixed layers; and/or a roughness of the barrier layer is less than half the thickness of the remaining semiconductor material layer, after allowing sufficient time for intermixing with any adjacent layers.

The adjacent layers may include the passivation layer, and, if present, the buffer layer. Roughness is a well-known parameter: Rq (root mean square) and Ra (arithmetic) deviations parametrize the surface vertical deviation from a central point. This parameter can be measured by AFM, TEM scans, and various other techniques.

According to an embodiment, the electrode layers are formed of NbTiN or NbN or TiN or TaN.

According to an embodiment, the second element is a transition metal that can form a silicide. According to a particular embodiment, the second element is chosen from the group consisting of Ti, Ta, W, and Co. In an exemplary embodiment, the second element may be deposited by PVD.

According to an embodiment, the semiconductor material layer is made of Si or Ge or a combination thereof.

The present disclosure is also related to a Josephson junction device including a Josephson junction stack according to the present disclosure.

The present disclosure is also related to a method for producing a Josephson junction stack according to the present disclosure, comprising the steps of:
- providing a support substrate,
- producing the first electrode layer on the support substrate,
- producing a semiconductor material layer on the first electrode layer,
- depositing a passivation layer on the semiconductor material layer, wherein the passivation layer is configured to prevent the semiconductor material of the semiconductor material layer from interacting with N in later processing steps, for example by depositing TiSix as described elsewhere herein, or for example by depositing a second element on the semiconductor material layer under conditions which cause intermixing of the second element with a top portion of the semiconductor material layer, so that the original semiconductor material layer is thinned and so that said layer formed of a mixture of Si with the second element is formed on the thinned semiconductor material layer,
- producing the second electrode layer on the passivation layer.

In other words, the step of depositing a passivation layer on the semiconductor material layer, wherein the passivation layer is configured to prevent the semiconductor material of the semiconductor material layer from interacting with N in later processing steps, helps to assure that the deposition or the presence of the second superconducting electrode layer does not lead to nitridation of the semiconductor layer. This layer may or may not intermix with the semiconductor layer.

According to an embodiment of the method, the first and second electrode layer are formed of NbTiN and said electrode layers are formed by physical vapour deposition (PVD), for example at a temperature between 300°C and 450°C, or at a lower temperature.

According to a further embodiment of the method, the passivation layer comprises Ti, and wherein the layer of Ti is deposited by PVD, for example at a temperature between 300°C and 450°C, or at a lower temperature.

According to a further embodiment of the method, the semiconductor material layer is produced by PVD at a temperature between room temperature and 450°C, preferably between room temperature and 90°C.

According to a further embodiment, the semiconductor material layer is formed of Si, in particular amorphous Si, or Ge, or a combination thereof.

According to a further embodiment, the method comprises comprising depositing a buffer layer on the first superconducting electrode layer, configured to prevent an interdiffusion of the semiconductor material of the semiconductor material layer into the first superconducting electrode layer.

According to a further embodiment, a thickness of the semiconductor material layer, after allowing sufficient time for intermixing with any adjacent layers, is thinner than the thickness of the combination of the passivation layer and, if present, the buffer layer, including any intermixed layers; and/or a roughness of the barrier layer is less than half the thickness of the remaining semiconductor material layer, after allowing sufficient time for intermixing with any adjacent layers; and/or the barrier layer (4,5) is deposited in-situ within a single tool cluster, preferably without any air break or air exposure.

The present disclosure is also related to a method for producing a Josephson junction device integrated in a superconducting digital circuit, comprising the steps of:
- producing a Josephson junction stack according to the method according to the present disclosure,
- patterning the stack, to thereby obtain the Josephson junction device, comprising a first and second electrode and a barrier sandwiched between said electrodes,
- producing conductors or superconductors of the circuit, wherein two of said conductors are respectively connected to the first and second electrode of the device.

### Brief description of the figures

Figures 1 to 5 illustrate the method steps for obtaining a Josephson junction stack in accordance with an embodiment according to the present disclosure.
Figures 6A and 6B schematically illustrate an exemplary embodiment of a method for obtaining a Josephson junction stack in accordance with an embodiment according to the present disclosure.

### Detailed description of the invention

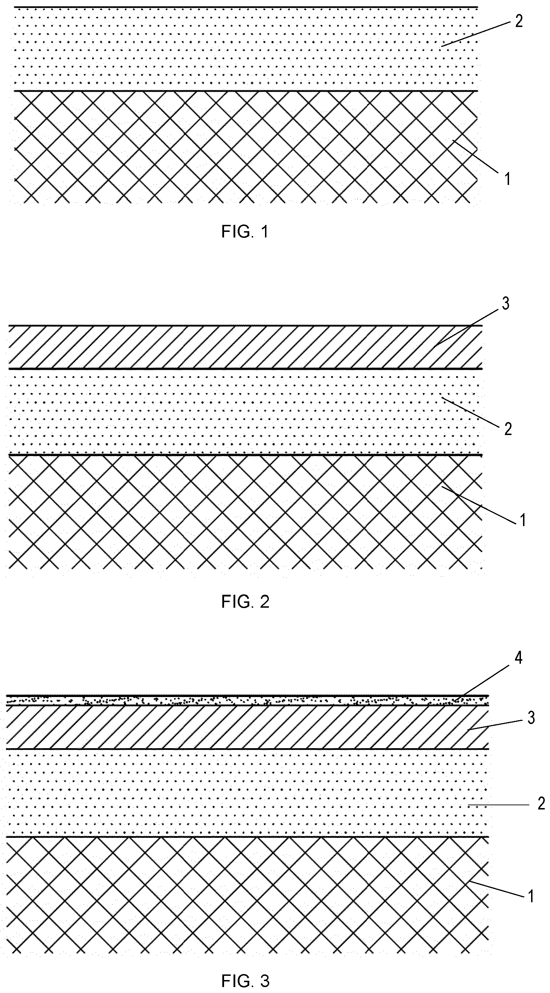

A method for producing a Josephson junction stack according to an embodiment according to the present disclosure is described with reference to Figures 1 to 5. A Josephson junction stack is defined within the present description as a stack of layers deposited on a substrate and suitable for forming a Josephson junction device by patterning those layers.

Unless it is stated otherwise, the materials cited in the following paragraphs are cited by way of example and these materials therefore do not limit the scope of the invention. All references to dimensions and parameters related to production methods are cited purely by way of example and therefore do not limit the scope of the invention. Alternatives for some of these dimensions, parameters or methods will be mentioned, where appropriate.

Figure 1 illustrates a small portion of a Si substrate 1 with a SiO₂ layer 2 on the upper surface of the substrate. The Si substrate may be a standard Si process wafer of 300 mm in diameter, or it may be the Si top layer of an SOI (silicon-on-insulator) substrate. Besides Si, the method according to the present disclosure is however applicable on other substrate types and materials thereof.

The thickness of the SiO₂ layer 2 is about 100 nm. As shown in Figure 2, a layer 3 of superconducting NbTiN of about 50 nm thick is deposited on the SiO₂ layer 2. This may be done by various methods known as such in the art. Layer 3 may for example be produced by Physical Vapour Deposition (PVD): with the substrate placed in a PVD chamber, Nb and Ti are co-sputtered at 754 W and 500 W, respectively in the presence of an argon flow of 17 standard cubic centimetres per minute (sccm) and a nitrogen flow of 15 sccm, at a temperature of 420 °C during 40 minutes. It is known to the skilled person that other deposition powers and gas flows can be applied during other deposition times, which results in other superconducting varieties of NbTiN, for example in terms of crystallinity or resistivity.

This is followed, as illustrated in Figure 3 by the deposition of a layer 4 of α-Si, which can be done also by PVD, at a temperature of 70°C, during about 20 min, resulting in a α-Si layer 4 having a thickness of about 10 nm. The deposition of α-Si takes place after moving the substrate to another PVD reactor, operated at the lower temperature of 70°C.

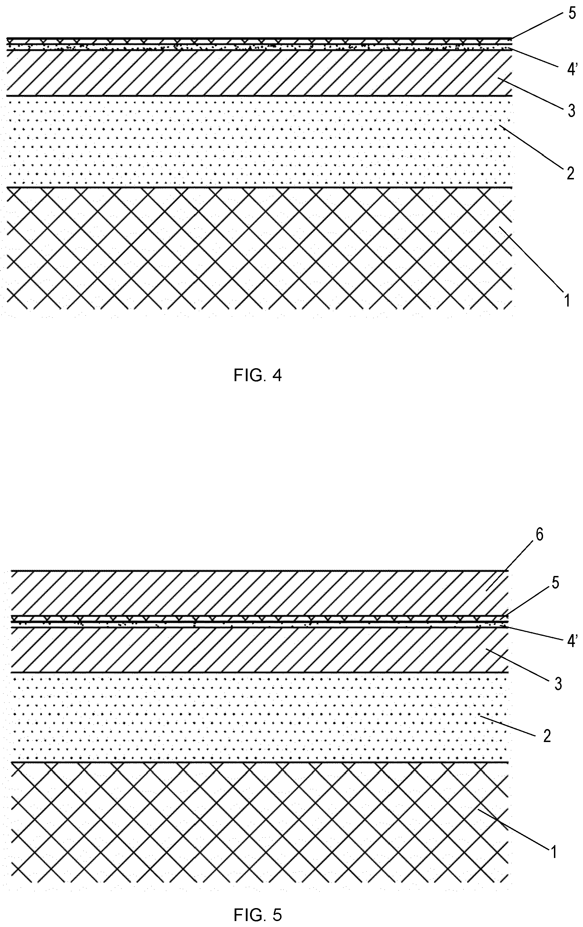

Thereafter, and with reference to Figure 4, Ti is deposited by PVD on the α-Si layer 4, also at 420°C (preferably again in the first chamber), during about 200 s. Of course, other transition metals than Ti could be used instead. During this deposition, Ti and at least a part of the Si intermix and form a mixed Ti/Si layer 5 on a thinned α-Si layer 4'. It will be understood that, depending on the thickness of Ti, a part of the Si will be turned into TiSix (with x ranging from 0.01 to 0.99), thus reducing the actual Si thickness. The overall intermixing is not necessarily only limited to this specific intermixing step, because further processing steps and in particular using a high temperature can contribute to further the intermixing. The original α-Si layer 4 is thinned as a consequence of the intermixing of Si from the original α-Si layer 4 with the deposited Ti. The thickness reduction of the original α-Si layer is in the order of 5 nm, leaving an α-Si layer 4' of about 5 nm thick (in principle, between 1 and 10 nm of Si layer 4' are left), while the mixed Ti/Si layer 5 has a thickness of about 5 nm. With reference to Figure 5, this is followed by the formation of a top NbTiN layer 6 of about the same thickness as the first NbTiN layer 3, again by co-sputtering Ti and Nb, for example applying the same parameters as applied for layer 3.

The function of the intermixed Ti/Si layer 5 is to act as a passivation layer that passivates the α-Si layer 4', i.e. it prevents the formation of SiN by a bonding reaction between Si from the α-Si layer 4' and N from the second electrode layer 6. Such SiN formation would lead to a much higher resistance of the Josephson junction, and thereby to a reduction of the critical current density of the junction.

Alternatively, if TiSi is deposited instead of Ti, there is no need for the intermixing, but the TiSi can act in a similar way as a passivation layer.

The resulting stack is a Josephson junction stack having a bottom electrode layer 3, a top electrode layer 6, an α-Si layer 4' on the bottom electrode layer and an intermixed Ti/Si passivation layer 5 on the α-Si layer, wherein the α-Si layer 4' and the intermixed Si/Ti layer 5 together form the barrier of the Josephson junction defined by the stack.

The use of superconducting NbTiN for the electrode layers 3 and 6 is advantageous compared to Nb because the Nb is bound to Ti and N and therefore cannot diffuse into the Si of layer 4. In addition, NbTiN is compatible with high processing temperatures applicable in BEOL processing, so that a Josephson junction device according to the present disclosure can be integrated in a BEOL structure, e.g. as used in standard CMOS processing. The deposition of NbTiN takes place at temperatures which are of the same order as the BEOL processing temperatures (preferably between 300°C and 450°C). For this reason, the material is compatible with said BEOL processing temperatures, i.e. diffusion of Nb is avoided.

Generally, the deposition temperature of Ti for forming the mixed layer 5 is preferably between 300°C and 450°C. As stated, the thicknesses of the layers described above are not limiting the scope of the invention. Thicknesses are applicable which enable the functionality of the various layers, namely for layers 3 and 6 to act as electrodes of a Josephson junction device, for layers 4 and 5' combined to act as barrier layer of said device, and for layer 5' to act as a passivation layer as explained above.

The Josephson junction stack illustrated in the drawings is produced on a SiO₂ layer 2 which isolates the stack from the Si substrate 1. This is required only if the Si substrate is a standard 300 mm Si wafer with low resistivity. When the Si wafer is a high resistivity wafer, the isolation layer 2 may be omitted. The stack can also be produced after first forming multiple other layers on the Si wafer including front end of line layers and back end of line layers as defined by a particular layout of an SDL circuit.

The temperature resistance of a Josephson junction stack according to the present disclosure combines with other advantages. The junction stack is highly scalable, i.e. it can be processed to form very small (e.g. on the order of 50-210 nm, preferably 100-210 nm in diameter) devices with good electrical properties in terms of the functionality of the devices in an SDL circuit. The critical current density scales exponentially as a function of the barrier thickness. This means that a required critical current is obtainable in a heavily scaled-down device, while still enabling a relatively thick α-Si barrier 4' of for example about 10nm. This is advantageous both for the reproducibility of the junction and for the operation speed: the high barrier thickness leads to a low capacitance, which increases the obtainable speed. Moreover, this is advantageous to avoid pinholes and similar defects for very thin barriers.

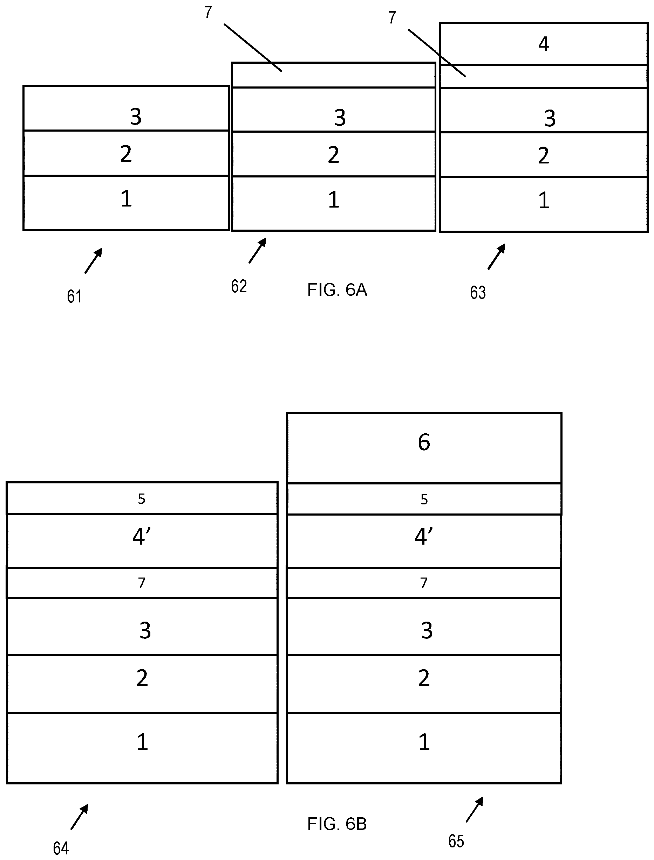

Figures 6A and 6B schematically illustrate an exemplary embodiment of a method for obtaining a Josephson junction stack in accordance with an embodiment according to the present disclosure.

In step 61, an oxide layer 2 is formed, which is optional, because the junction will also work if the first superconducting electrode layer 3 is deposited directly on the semiconductor material layer 4, but high-resistivity semiconductor material may need to be used. For example, 3 kOhm*cm can be used for superconducting junctions directly on a semiconductor material substrate.

In step 62, a buffer layer 7 is formed, which is also optional. It does not dramatically change the junction properties as long as it is thin, preferably in the range of 1-5 nm.

The buffer layer 7 may for example be deposited by any of various methods known in the art, for example by Physical Vapour Deposition (PVD), wherein the substrate is placed in a PVD chamber, and targets (e.g. Ti and Si, or TiSix) are then co-sputtered.

The buffer layer 7 will, in some cases, be able to interdiffuse with the semiconductor material layer, allowing to better control its thickness and various other properties.

In step 63, a semiconductor material layer 4 is formed.

In step 64, a passivation layer 5 is formed, which may be the same as or different from the buffer layer 7 formed in step 62. The passivation layer 5 is configured to protect the semiconductor material from interacting with the N of the superconducting nitride material of the second superconducting electrode layer 6, thus potentially forming a semiconductor-nitride. Such kinds of interactions could lead to unpredictable device behavior.

A further benefit of the passivation layer 5 is that it can help protect against forming a nitrogen-based compound with any other chemicals that may be used in the fabrication process, even after the initial deposition.

The passivation layer 5 can be deposited for example from a TiSi target, formation by co-sputtering, or by alloying. Also, it can be done by CVD and ALD.

The passivation layer 5 is deposited directly on top of the semiconductor material layer 4, because otherwise it does not achieve the passivation.

In step 65, a second superconducting electrode layer 6 is formed, which is a superconducting nitride (e.g. NbTiN, NbN, TiN, or TaN). If a non-nitride superconductor were to be used, there would not be risk of forming semiconducting nitride that could lead to unpredictable device behavior.

The present disclosure is explicitly not limited to the use of amorphous Si in the barrier, but explicitly considers the use of other semiconductor materials, including but not limited to Si, amorphous Si, Ge, etc. Any other components of the junction are not limited to the above-named materials. The electrode layers 3 and 6 are generally formed of a superconducting material, preferably a superconducting material comprising nitrogen. Alternatives to NbTiN include for example NbN or TiN or TaN.

Other elements instead of Ti may be used for the same function, namely obstructing the formation of SiN by forming a mixed layer formed of said element and Si between the α-Si layer 4' and the second superconducting electrode layer 6. Such elements include for example Ta and Co, and other transition metals.

As to the method according to the present disclosure for forming the Josephson junction stack, other processes can be used for forming the layers of the stack. For example Atomic Layer Deposition can be used to form the electrode layers 3 and 6, the α-Si layer 4 and the Ti layer 5. Other suitable methods for forming the bottom and top electrode layers 3 and 6 include single target PVD and CVD (chemical vapour deposition).

An actual Josephson junction device according to the present disclosure, integrated in a layer structure of an integrated circuit chip, can be produced by methods applied for the production of currently known chips comprising SDL circuits. This includes producing a Josephson junction stack in accordance with the present disclosure, and patterning the stack so as to obtain the Josephson junction device comprising a patterned portion of the bottom electrode layer 3, the barrier layer 4'+5 and the top electrode layer 6, respectively forming the first electrode, barrier and second electrode of the device. Following this, conductors are produced wherein two of said conductors are respectively connected to the first and second electrode of the device. An example of a Josephson junction device integrated in an SDL chip is disclosed in patent publication document US20230210022. A Josephson junction stack according to the present disclosure, produced by any of the methods described above, can be used to produce the device as disclosed in the cited application and in other known examples of Josephson junction devices applied in an SDL circuit.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A Josephson junction stack comprising a first superconducting electrode layer (3), a barrier layer (4',5) on the first superconducting electrode layer (3) and a second superconducting electrode layer (6) on the barrier layer, **characterized in that**:
- the second superconducting electrode layer (6) is formed of a superconducting nitride material,
- the barrier layer comprises a stack of a semiconductor material layer (4') on the first superconducting electrode layer (3) and directly on said semiconductor material layer: a passivation layer (5) configured to prevent the semiconductor material of the semiconductor material layer (4') from interacting with the N of the superconducting nitride material of the second superconducting electrode layer (6).

2. A Josephson junction stack according to claim 1, comprising a buffer layer (7), between the semiconductor material layer (4') and the first superconducting electrode layer (3), configured to prevent an interdiffusion of the semiconductor material of the semiconductor material layer (4') into the first superconducting electrode layer (3).

3. A Josephson junction stack according to any one of the preceding claims, wherein a thickness of the semiconductor material layer, after allowing sufficient time for intermixing with any adjacent layers, is thinner than the thickness of the combination of the passivation layer and, if present, the buffer layer, including any intermixed layers; and/or wherein a roughness of the barrier layer is less than half the thickness of the remaining semiconductor material layer, after allowing sufficient time for intermixing with any adjacent layers.

4. A Josephson junction stack according to any one of the preceding claims, wherein the electrode layers (3,6) are formed of NbTiN or NbN or TiN or TaN.

5. A Josephson junction stack according to any one of the preceding claims, wherein the second element is a transition metal that can form a silicide, and is preferably chosen from the group consisting of Ti, Ta, W, and Co.

6. A Josephson junction stack according to any one of the preceding claims, wherein the semiconductor material layer (4) is formed of Si, in particular amorphous Si, or Ge, or a combination thereof.

7. A Josephson junction device including a Josephson junction stack according to any one of the preceding claims.

8. A method for producing a Josephson junction stack according to any one of claims 1 to 6, comprising the steps of:
- providing a support substrate (1,2),
- producing the first electrode layer (3) on the support substrate,
- producing a semiconductor material layer (4) on the first electrode layer,
- depositing a passivation layer (5) on the semiconductor material layer, wherein the passivation layer (5) is configured to prevent the semiconductor material of the semiconductor material layer (4') from interacting with N in later processing steps,
- producing the second electrode layer (6) on the passivation layer (5).

9. The method according to claim 8, wherein the first and second electrode layer (3,6) are formed of NbTiN and wherein said electrode layers are formed by physical vapour deposition (PVD).

10. The method according to claim 8 or 9, wherein the passivation layer comprises Ti, and wherein the layer of Ti is deposited by PVD.

11. The method according to any one of claims 8 to 10, wherein the semiconductor material layer (4) is produced by PVD at a temperature between room temperature and 450°C, preferably between room temperature and 90°C.

12. The method according to any one of claims 8-11, wherein the semiconductor material layer (4) is formed of Si, in particular amorphous Si, or Ge, or a combination thereof.

13. The method according to any one of claims 8-12, comprising depositing a buffer layer (7) on the first superconducting electrode layer (3), configured to prevent an interdiffusion of the semiconductor material of the semiconductor material layer (4') into the first superconducting electrode layer (3).

14. The method according to any one of claims 8-13, wherein a thickness of the semiconductor material layer, after allowing sufficient time for intermixing with any adjacent layers, is thinner than the thickness of the combination of the passivation layer and, if present, the buffer layer, including any intermixed layers; and/or wherein a roughness of the barrier layer is less than half the thickness of the remaining semiconductor material layer, after allowing sufficient time for intermixing with any adjacent layers; and/or wherein the barrier layer (4,5) is deposited in-situ within a single tool cluster, preferably without any air break or air exposure.

15. A method for producing a Josephson junction device integrated in a superconducting digital circuit, comprising the steps of:
- producing a Josephson junction stack according to the method of any one of claims 8 to 14,
- patterning the stack, to thereby obtain the Josephson junction device, comprising a first and second electrode and a barrier sandwiched between said electrodes,
- producing conductors or superconductors of the circuit, wherein two of said conductors are respectively connected to the first and second electrode of the device.
